(19)

**Europäisches Patentamt**
**European Patent Office**
**Office européen des brevets**

(11) **EP 4 242 192 A1**

(12) **EUROPEAN PATENT APPLICATION**

(43) Date of publication:
**13.09.2023 Bulletin 2023/37**

(21) Application number: **22161680.8**

(22) Date of filing: **11.03.2022**

(51) International Patent Classification (IPC):
**C04B 35/119** (2006.01)          **C04B 35/634** (2006.01)
**H01L 29/00** (2006.01)          **H01L 33/00** (2010.01)
**H05K 1/03** (2006.01)

(52) Cooperative Patent Classification (CPC):
**C04B 35/119; C04B 35/63416; C04B 35/6342;**
**H01L 29/00; H05K 1/0306;** C04B 2235/3225;
C04B 2235/3246; C04B 2235/3418;
C04B 2235/5436; C04B 2235/5445;
C04B 2235/5472; C04B 2235/6022;
C04B 2235/6025; C04B 2235/77; C04B 2235/785;

(Cont.)

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **CeramTec GmbH**
**73207 Plochingen (DE)**

(72) Inventors:
• **BARNAU, Linda**
  **95659 Arzberg (DE)**
• **SCHREINER, Hans-Jürgen**
  **91217 Hersbruck (DE)**

(74) Representative: **Maikowski & Ninnemann**
**Patentanwälte Partnerschaft mbB**
**Postfach 15 09 20**
**10671 Berlin (DE)**

(54) **CERAMIC SUBSTRATE**

(57)     The present invention relates to a ceramic substrate comprising: aluminum oxide ($Al_2O_3$) with an average grain size between 1.0 and 1.9 $\mu$m, preferably between 1.2 and 1.7 $\mu$m, more preferably between 1.3 and 1.6 $\mu$m, even more preferably between 1.31 and 1.55 $\mu$m; Zirconium dioxide ($ZrO_2$) with an average grain size between 0.51 and 1.0 $\mu$m, preferably between 0.55 and 0.9 $\mu$m, more preferably between 0.6 and 0.8 $\mu$m, even more preferably between 0.65 and 0.75 $\mu$m, Yttrium oxide ($Y_2O_3$) and further components.

EP 4 242 192 A1

(52) Cooperative Patent Classification (CPC): (Cont.)
  C04B 2235/786

**Description**

Ceramic compositions or substrates are widely used as substrates for mounting electronic components via a metal layer. In this case a ceramic composition acts as an isolating layer on which a metal layer is disposed. An electronic component may then be provided on the metal layer.

Ceramic compositions or substrates used for mounting electronic components are required to have excellent discharge properties, in particular a high coefficient of thermal conductivity. At the same time the ceramic substrate shall have a good mechanical strength as a mounting substrate. This is in particular necessary, when reducing the thickness of the ceramic substrate due to the ongoing miniaturization of electronic components. Therefore, a ceramic substrate are required that have both a high coefficient of thermal conductivity and a high mechanical strength.

A known type of ceramic substrate used in such a set-up is an alumina substrate containing zirconium oxide (zirconia toughened alumina substrate-ZTA substrate).

Such a ceramic substrate is for example described in EP 2 911 994 B1 refers to a metal ceramic substrate comprising $Al_2O_3$, $ZrO_2$ and $Y_2O_3$, wherein the average grain size of the used $Al_2O_3$ is between 2 and 8 $\mu$m. However, the document does not define if the $Al_2O_3$ grain size refers to the grain size of the starting material or the sintered material. There is also no method for determining the grain size provided.

In EP 3 315 476 B1 a ceramic substrate is described that comprises aluminum oxide crystals with an average crystal size of not less than 1.0 $\mu$m and not greater than 1.5 $\mu$m and zirconium oxide crystals with an average crystal size of not less than 0.3 $\mu$m and not greater than 0.5 $\mu$m.

The authors describe that when the average crystal size of zirconium oxide exceeds 0.5 $\mu$m the mechanical strength is hampered. When the crystal size of aluminum oxide is less than 1.0 $\mu$m a high coefficient of thermal conductivity is not achieved. At the same time if the crystal size of aluminum oxide exceeds 1.5 $\mu$m a high mechanical strength is not achieved.

Thus, in order to achieve both a good thermal conductivity and a mechanical strength a finetuning of the crystal size of aluminum oxide and zirconium oxide seems to be required.

Thus, the object of the present invention was to provide a ceramic substrate combining a good thermal conductivity and mechanical strength.

This object was solved by the ceramic substrate according to claim 1.

Accordingly, a ceramic substrate is provided that comprises:

- aluminum oxide ($Al_2O_3$) with an average grain size between 1.0 and 1.9 $\mu$m, preferably between 1.2 and 1.7 $\mu$m, more preferably between 1.3 and 1.6 $\mu$m, even more preferably between 1.31 and 1.55 $\mu$m;
- Zirconium dioxide ($ZrO_2$) with an average grain size between 0.51 and 1.0 $\mu$m, preferably between 0.55 and 0.9 $\mu$m, more preferably between 0.6 and 0.8 $\mu$m, even more preferably between 0.65 and 0.75 $\mu$m,
- Yttrium oxide ($Y_2O_3$), silicon oxide ($SiO_2$) and further components, such as $HfO_2$. TiO2, $Cr_2O_3$, $Fe_2O_3$, $CeO_2$,$Na_2O$, MgO, $K_2O$, CaO, SrO

The ceramic substrate of the invention is characterized by a good thermal stability and a good mechanical strength as illustrated by the data provided below. In particular, the good mechanical strength was not expected due to the grain size of $ZrO_2$ determined in the ceramic substrate. In contrast to the prior art as described above a $ZrO_2$ grain size of more than 0.5 $\mu$m did not hamper the mechanical strength, on the contrary it was even possible to increase the mechanical strength to a certain extent.

The present ceramic substrate has a dense crystal arrangement and consists of two phases of $ZrO_2$ and $Al_2O_3$ grains. The $ZrO_2$ grains are tetragonal or monocline.

In an embodiment, the present ceramic substrate has the following composition:

- 85-95 wt%, preferably 88- 93 wt%, more preferably 89-91 wt% (based on the overall weight of the ceramic substrate) of aluminum oxide ($Al_2O_3$),
- 4 - 14 wt%, preferably 6-11 wt%, more preferably 8-10 wt% (based on the overall weight of the ceramic substrate) of zirconium dioxide ($ZrO_2$)
- 0.2-0.8 wt%, preferably 0.3-0.7 wt%, more preferably 0.4 - 0.6 wt% (based on the overall weight of the ceramic substrate) of yttrium oxide ($Y_2O_3$), and
- 0.1-0.5 wt%, preferably 0.2-0.4 wt%, more preferably 0.25 - 0.35 wt% (based on the overall weight of the ceramic substrate) of silicon oxide ($SiO_2$), and
- less than 0.6 wt%, preferably 0.1-0.45 wt%, more preferably 0.2- 0.35 wt% (based on the overall weight of the ceramic substrate) further components wherein the sum of all ingredients always adds up to 100wt%.

Yttrium oxide is contained in commercially available zirconium oxide as stabilizer. Besides yttrium oxide, commercially available Zirconium oxide also contains hafnium oxide HfO2. HfO2 may be present within a range of not less than 1 part by mass and not greater than 3 part by mass per 100 parts of zirconium oxide. Yttrium oxide may be present in zirconium oxide in an amount of up to 6 wt%, preferably about 5-5.5 wt%. Preferably 2,5-3,5 mol%, more preferably 3 mol% of $Y_2O_3$ act as a stabilizer for $ZrO_2$ (Based on the amount of the $ZrO_2$). Commercially Zirconium oxide also contains further components such as up to 0.55 wt% aluminum oxide $Al_2O_3$.

As mentioned above the ceramic substrate also contains sintering agents, in particular silicon dioxide (SiO2). A preferred sintering agent is $SiO_2$. $SiO_2$ may be contained in the ceramic substrate in an amount up to 0.5 wt%, preferably up to 0.35 wt%.

In an embodiment the ceramic substrate has a bending strength (measured according to ASTM C1499-15) of more than 620 MPa, preferably of more than 650 MPa, more preferably of more than 670 MPa, even more preferably of more than 680 MPa, such as 690 MPa. The bending strength may be in a range between 620 - 800 MPa, preferably in a range between 630 -760 MPa, even more preferably in a range between 650 - 730 MPa.

In another embodiment the ceramic substrate has a thermal conductivity (measured at 20 °C according to ISO 18755:2005) of more than 20 W/m*K, preferably of more than 22 W/m*K, even more preferably of more than 24 W/m*K. The thermal conductivity may be in a range between 20 - 40 W/m*K, preferably between 22- 35 W/m*K, more preferably between 23- 30 W/m*K, even more preferably between 24 - 27 W/m*K.

In yet a further embodiment the ceramic substrate has a modulus of elasticity or E-module (Young's Modulus) as determined in a Grindosonic (method described in the experimental section) of more than 310 GPa, preferably of more than 350 GPa, even more preferably of more than 360 GPa. The E-module may be in a range between 310 - 400 GPa, preferably in a range between 330 - 390 GPa, more preferably in a range between 350 - 380 GPa.

It is furthermore preferred, if the ceramic substrate has a fracture toughness $K_{Ic}$ Niihara (measured according to the IF-method as described in the experimental section) of 3-5 MPa $m^{1/2}$, preferably of 3.5 - 4.5 MPa $m^{1/2}$, more preferably of 3.8-4.2 MPa $m^{1/2}$. The Vickers Hardness of the ceramic substrate is between 1500 - 2000 HV, preferably between 1600 - 1900 HV, more preferably between 1700 - 1850 HV, even more preferably between 1750 - 1830 HV.

It is also preferred, if the ceramic substrate has a surface roughness Ra (measured according to DIN EN ISO 4288) of less than 0.5 $\mu$m, preferably of less than 0.4 $\mu$m, more preferably of less than 0.2 $\mu$m, such as 0.19 $\mu$m.

The bulk density (measured according to DIN 993-1 / ISO 18754) of the ceramic substrate is more than 3.5 g/cm$^3$, preferably of more than 3.95 g/cm3, even more preferably of more than 4 g/cm$^3$, such as 4.0-4.1 g/cm$^3$.

In another embodiment the ceramic substrate has an electric breakdown strength (measured at 20°C following DIN EN 60243 ff) of more than 20 kV/mm, preferably of more than 25 kV/mm. more preferably of more than 30 kV/mm. The electric breakdown strength may be in a range between 20 - 40 kV/mm, preferably in a range between 25 - 35 kV/mm, more preferably between 28 - 33 kV/mm.

Specific heat capacity (measured using DSC device as described in the experimental section) of the ceramic substrate is of more than 620 J/gK, preferably of more than 650 J/gK, more preferably more than 670 J/gK. The specific heat capacity may be in a range between 620-750 J/gK, preferably in a range between 650 - 720 J/gK, more preferably between 670-710 J/gK.

Coefficient of thermal expansion CTE (determined using a dilatometer as described in the experimental section) of the ceramic substrate is at 20-300 °C of more than 7 $10^{-6}$/K, at 300-600 °C of more than 8$10^{-6}$/K, at 600-900 °C of more than 8.6 $10^{-6}$/K.

The ceramic substrate may be obtained in a method comprising the following steps:

- Providing a mixture of at least one first type of aluminum oxide having a particle size between d50 0.,1-0,8 $\mu$m, preferably d50 0.3-0,6 $\mu$m and at least one second type of aluminum oxide having a particle size between d50 0.9-1.7 $\mu$m, preferably 1.0-1.5 $\mu$m,
- Providing a mixture of at least one first type of zirconium oxide having a particle size between d50 0.2-0.5 $\mu$m preferably d50 0.25-0.35; and at least one second type of zirconium oxide having a particle size between d50 0.8-1.4 $\mu$m, preferably d50 0.9-1.25 $\mu$m,
- Combining the aluminum oxide mixture and the zirconium oxide mixture and optionally further additives and dispersing the mixture in a mill,
- Adding a binder, such as polyvinylalcohol (PVA) or polyvinylbutyral (PVB), to the dispersed mixture of aluminum oxide and zirconium oxide,
- Shaping the dispersed mixture of aluminum oxide, zirconium oxide and binder into a film, and
- Sintering the film to provide the ceramic substrate.

In an preferred embodiment of the present method, the first grade of $Al_2O_3$ may have a particle size d50 of 0.3-0.6 $\mu$m and d90 of less than 3.0, preferably less than 2.0 $\mu$m and the second grade of $Al_2O_3$ may have a particle size d50 of 1.0-1.5 $\mu$m and d90 of less than 4.0, preferably less than 3.6 $\mu$m

In another preferred embodiment of the present method, the first grade of $ZrO_2$ may have a particle size d50 of 0.25-0.35 $\mu$m and d98 less than 2.0 $\mu$m and the second grade of $ZrO_2$ may have a particle size d50 of 0.9-1.25 $\mu$m, and d80 1.5-2.2 $\mu$m

In a preferred embodiment of the present method, the following mixture is provided as aluminum oxide starting material:

- 42.5 - 47.5 wt%, preferably 44 - 46.5 wt%, more preferably 44.5- 45.5 wt% of the at least one first type of aluminum oxide having a particle size between d50 0.1-0.8 $\mu$m, preferably d50 0.3-0.6 $\mu$m and
- 42.5 - 47.5 wt%, preferably 44 - 46.5 wt%, more preferably 44.5- 45.5 wt% of the at least one second type of aluminum oxide having a particle size between d50 0.9-1.7 $\mu$m, preferably 1.0-1.5 $\mu$m.

Thus, the two types of aluminum oxides having preferably different particle sizes and used as starting material are provided in a weight ratio of about 1 : 1, i.e. about 50 wt% of each type.

In another preferred embodiment of the present method, the following mixture is provided as zirconium oxide starting material:

- 1.2 - 4.2 wt%, 1.8 - 3.3 wt%, 2.4 -3 wt% of the at least one first type of zirconium oxide having a particle size between d50 0,.2-0.5 $\mu$m preferably d50 0.25-0.35 $\mu$m and
- 2.8 - 9.8 wt%, 4.2 - 7.7 wt%, 5.6 - 7 wt% of the at least one second type of zirconium oxide having a particle size between d50 0.8-1.4 $\mu$m, preferably d50 0.9-1.25 $\mu$m.

Thus, preferably about 30 wt % of at least one first type of zirconium oxide having a particle size between d50 0.2-0.5 $\mu$m preferably d50 0.25-0.35 $\mu$m and about 70 wt% at least one second type of zirconium oxide having a particle size between d50 0.8-1.4 $\mu$m, preferably d50 0.9-1.25 $\mu$m are used as starting material.

In a further embodiment of the present method sintering aids such as $SiO_2$ and organic compounds such as binder (for example PVA or PVB) are added to the $Al_2O_3$ / $ZrO_2$ mixture.

The powdery mixture of $Al_2O_3$ / $ZrO_2$ (containing $Y_2O_3$) / sintering aids is subsequently added into a mill together with a solvent such as water or organic solvents, preferably containing a dispersing agent to obtain a dispersion

In a next step, a green sheet is obtained by a doctor blade method using this slurry. Alternatively, using a granulated body prepared by spray-drying the slurry using a spray dryer, a green sheet is obtained by a powder press molding method or a roller compaction method.

Next, a compact may be obtained by performing profile shape machining with a metal mold or a laser. The green sheet may be used directly as a compact and subjected to profile shape machining with a laser after being subject to firing. In addition, taking into consideration mass productivity, a multipiece compact is preferably used.

The sintering step is carried out in a furnace. The sintering temperature is preferably 1400-1700 °C.

The ceramic substrate of the invention may be used in an electronic device. Such an electronic device may include the ceramic substrate as a support with a metal layer located on one or both surfaces of the ceramic substrate. An electronic component may be provided on the metal layer.

The electronic component provided on the metal layer of the ceramic substrate may be used, for example, in a semiconductor element such as an insulated gate bipolar transistor (IGBT) element, an intelligent power module (IPM) element, a metal oxide semiconductor field effect transistor (MOSFET) element, an LED element, a freewheeling diode (FWD) element, a giant transistor (GTR) element, or a Schottky barrier diode (SBD). In addition, the electronic component may be used in a heat-generating element for a sublimation type thermal printer head or a thermal inkjet printer head. Further, the electronic component may be used in a Peltier element.

The invention is now explained in more detail with reference to the examples.

The following Examples are included to demonstrate certain aspects and embodiments of the invention as described in the claims. It should be appreciated by those of skill in the art, however, that the following description is illustrative only and should not be taken in any way as a restriction of the invention.

### I. Synthesis

The starting materials $ZrO_2$, $Al_2O_3$ and $SiO_2$ are subjected to an incoming raw material inspection. Two different grades are used for both the $Al_2O_3$ and the $ZrO_2$ to achieve the grain size distributions shown in the final product.

The mass preparation (slurry) takes place in a mill. The mass preparation contains mixing of the raw materials, meaning the ceramic starting material and the organic compounds. The slurry is cast to form a ceramic green film. The green film is cut to specified dimensions. The ceramic films are sintered at 1400 bis 1700°C.

### II. Analytics

**Grain size:** planimetric method applied to the sintered ceramic substrate

The planimetric method applied for determining the average crystal grain size of alumina and zirconia is now described. First, the surface of the ceramic substrate 1 is subjected to mirror finishing and is heat-treated in a temperature range from 50 to 100°C lower than the firing temperature. The heat-treated surface is then used as a measurement surface and is photographed at a multiplication factor of 5000 times using an SEM. Next, the photographed image data is analyzed using image analysis software (for example, Win ROOF available from the Mitani Corporation). As a result, the data for the respective crystal grain sizes of alumina and zirconia present in the image data can be obtained.

Although the ceramic substrate may contain crystals with a crystal grain size of less than 0.05 mm, only crystals with a crystal grain size of at least 0.05 mm are targeted in the analysis by the image analysis software. In addition, when image analysis software such as that described above is used, separate measurements are possible because there is a difference in color tone between alumina crystal grains and zirconia crystal grains.

The average value of an equivalent circle diameter of each crystal grain calculated from the area of each crystal grain of alumina is the average crystal grain size of alumina, and the average value of an equivalent circle diameter of each crystal grain calculated from the area of each crystal grain of zirconia is the average crystal grain size of zirconia.

The standard deviation of the crystal grain size of alumina can be determined by the same method as that used to determine the average crystal grain size described above from the data of the crystal grain size of alumina obtained using image analysis software.

**Determination of the fracture toughness (KIc value) of ceramic substrates according to the IF method with evaluation according to Niihara and Anstis**

The KIc value was determined using the IF method as described in A. G. Evans, E. A. Charles, J. Am. Ceram. Soc. 1976, 56, 371-372. Und G. R. Anstis, P. Chantikul, et al., J. Am. Ceram. Soc. 1981, 64, 533-538.

In short: substrates were supplied. A sample was broken out of each substrate, embedded in Clarocit and ground and polished.

Subsequently, a large number of Vickers indentations were made in each substrate so that there were at least 5 (but usually up to 10) indentations of sufficient quality. Sufficient quality means that the cracks running away from the corners of the indentations were clearly identifiable (one clean, relatively straight crack each with a relatively clearly identifiable crack end and no branching) and no large breakouts were visible on the indentation. The creation of these clear cracks without large break-outs in the indentation first required the determination of the appropriate indentation load. If the indentation load is too low, no cracks will appear. If the indentation load is too high, either the substrate breaks or massive chipping occurs in the indentation, making it impossible to evaluate the indentation. With lower indentation loads, no or too short cracks occur.

The evaluation and thus the calculation of the $K_{Ic}$ value was done according to the formula of Niihara as well as Anstis:

$$K_{Ic,Niihara} = 0{,}018 H \sqrt{a} \left(\frac{E}{H}\right)^{0,4} \left(\frac{c}{a} - 1\right)^{-0,5}$$

*K*IC, Niihara= fracture toughness [MPa√m].
*HH* = Vickers hardness value in MPa
*EE* = E-modulus [MPa]
c = crack length + half diagonal of the hardness indentation [m].
*aa* = half diagonal of the hardness impression [m].

$$K_{Ic,Anstis} = 0{,}032 H \sqrt{a} \left(\frac{E}{H}\right)^{0,5} \left(\frac{c}{a}\right)^{-1,5}$$

*K*IC, Anstis= fracture toughness [MPa√m]
*HH* = Vickers hardness value in MPa
*EE* = E-modulus [MPa]
c = crack length + half diagonal of the hardness indentation [m].
*aa* = half diagonal of the hardness impression [m].

For the modulus of elasticity, literature values were used (360 GPa). The hardness values were determined and output directly when the hardness indentation was applied. The crack lengths and indentation diagonals were measured directly on the tester after each hardness indentation.

The hardness and Klc values of the measured samples are shown in table 1 below. The mean value with standard deviation is given in each case. As written above, the mean values were formed from at least 5 measured hardness impressions per material.

Table 1: Klc values according to the IF method and the Niihara and Anstis formulas

| Sample no. | Vickers hardness | $K_{Ic}$ [MPa m$^{1/2}$] Niihara | $K_{Ic}$ [MPa m$^{1/2}$] Anstis |
|---|---|---|---|
| 1 | 1790 +/- 27 | 4,118 +/- 0,063 | 2,807 +/- 0,076 |
| 2 | 1828 +/- 14 | 4,094 +/- 0,065 | 2,749 +/- 0,082 |
|  |  |  |  |

**Specific heat capacity**

The specific heat capacity or heat capacity is a measurable physical quantity that corresponds to the ratio of the heat supplied to an object to the resulting temperature change.

The equation is as follows:

$$Specific\ heat\ capacity = \frac{heat\ flow\ (Q)}{sample\ mass\ (g) * change\ in\ temperature\ (\Delta T)}$$

$$[cp] = \frac{J}{g \cdot K}$$

The specific heat is the amount of heat needed to raise the temperature of one gram of the material by 1 degree Celsius.

DSC measurements are done according to DIN 51007 and ISO 11357-1.

Functional principle of a heat flow DSC:
A DSC measuring cell consists of a furnace and an integrated sensor with corresponding footprints for sample and reference crucibles. The sensor surfaces are connected to thermocouples or are even part of the thermocouples themselves. This makes it possible to record both the temperature difference between the sample and reference sides (DSC signal) and the absolute temperature of the sample or reference side. Due to the heat capacity cp of the sample, the reference side (usually empty crucible) usually heats up faster than the sample side when heating up a DSC measuring cell, i.e. the reference temperature (TR) rises somewhat faster than the sample temperature (TP). Both curves behave parallel to each other during heating with a constant heating speed - until a sample reaction occurs. In the present case, the sample begins to melt at t1. During the melting process, the temperature in the sample does not change; however, the temperature of the reference side remains unaffected and continues to rise linearly. After the melting is finished, the sample temperature also increases again and shows a linear slope again from time t2 onwards.

The difference signal ($\Delta T$) of the two temperature curves is used. In the middle area of the curve, a peak is formed by the difference formation, which represents the endothermic melting process. Depending on whether the reference temperature was subtracted from the sample temperature during the difference formation or vice versa, the resulting peak points upwards or downwards in the graph. The area of the peak is related to the heat content of the conversion (enthalpy in J/g).

**E-Module (Young's modulus)**

The measurement setup consists of the Grindosonic with connected microphone or piezo sensor, a suitable clapper and a special specimen holder with supports matched to the respective specimen geometry. The device is also connected to the PC for recording the measured values. Elasticity of a material means that a material deforms under external load, but returns to its original state as soon as the load disappears. This strain is linearly proportional to the applied load (Hooke's Law). The quotient of strain and load results in a propornality factor known as the Young's modulus of the material.

**Coefficient of thermal expansion CTE**

A measuring device from company Netzsch is used to measure the linear thermal expansion of a sample as a function of temperature. Thermal expansion is a measure of the change in volume of a body in response to changes in temperature. Measuring according to manufacturer's specification DIL 402 Expedis Select & Supreme - NETZSCH Analyzing & Testing (netzsch-thermal-analysis.com)

The following table summarizes parameter values measured by standard methods table 2

| parameter | unit | standard |
|---|---|---|
| Thermal conductivity | W/mK | ISO 18755:2005 |
| Bulk density | g/cm$^3$ | DIN 993-1 / ISO 18754 |
| Specific heat capacity | J/gK | DSC measurement as described above |
| Electrical breakdown strength | kV/mm | Following DIN EN 60243-ff |
| E-Modul | GPa | Grindosonic as decscribed above |
| Bending strength (Sigma und Weibull, BBF) | MPa | ASTM C1499 |
| KIC | [MPa m1/2] | IF Method as described above |
| RFA (element analyis) | Wt% | DIN 51001/ DIN EN ISO 12677 |
| CTE | 10^-6mm/°C | Dilatometer as described above |
| Surface roughness, Ra | $\mu$m | following Din EN ISO 4288 |

In the following tables 3-4 several examples according to the invention (inventive examples IE 1-2) and their properties are summarized.

In table 3 type and amount of starting material is provided for the inventive examples. The first grade of $Al_2O_3$ has a particle size d50 of 0.5 $\mu$m and d90 of 2.0 $\mu$m and the second grade of $Al_2O_3$ has a particle size d50 of 1.3 $\mu$m and d90 of 3.2 $\mu$m. The first grade of $ZrO_2$ has a particle size d50 of 0.3-0.32 $\mu$m and d90 of 0.60 $\mu$m and the second grade of $ZrO_2$ has a particle size d50 of 1.17 $\mu$m and d80 of 2.06 $\mu$m.

Further additives that are used are $SiO_2$ as sintering agent,

Table 3

| | IE1 | IE2 |
|---|---|---|
| **starting material** | wt% | wt% |
| $Al_2O_3$ first grade | 45,110 | 45,110 |
| $ZrO_2$ first grade | 6,637 | 6,637 |
| $ZrO_2$ second grade | 2,844 | 2,844 |
| $Al_2O_3$ second grade | 45,110 | 45,110 |
| $SiO_2$ | 0,299 | 0,299 |

Further additives may be added, wherein the sum of all ingredients always adds up to 100wt%.

The ceramic substrate obtained contains $Al_2O_3$, $ZrO_2$, $Y_2O_3$ and $SiO_2$. Further components in the ceramic substrates can be: $Na_2O$, MgO, $K_2O$, CaO, $TiO_2$, $Cr_2O_3$, $Fe_2O_3$ ,SrO, CeO.

Table 4 summarizes the mechanical, thermal and electrical properties of the inventive examples of Table 3.

As can be seen in Table 4, bending strength reaches a high value of over 650 MPa, even over 680 MPa while the thermal conductivity is 24 - 25 W/(m*K). Thus, the inventive examples combine both an excellent mechanical strength and a good thermal conductivity.

Table 4

| | Condition | Unit | IE1 | IE2 |
|---|---|---|---|---|
| Average $ZrO_2$ grain size | | $\mu$m | 0.65 | 0.72 |

(continued)

|  | | Condition | Unit | IE1 | IE2 |
|---|---|---|---|---|---|
| Bulk density | | | | >95% der theoretischen Dichte | >95% der theoretischen Dichte |
| Surface roughness Ra | | | $\mu$m | i.O. | i.O. |
| Mechanial | Bending strenght | | MPa | >650 | >680 |
| | Modulus of elasticity | | GPa | >355 | >360 |
| Thermal | CTE | (20-300 °C) (300-600°C) (600-900°C) | $10^{-6}$/K | i.O. | i.O. |
| | Thermal conductivity | 25 °C | W/(m·K) | >24 | >24 |
| | specific heat capacity | 25 °C | J/(kg·K) | 700 | 670 |
| Electrical | Breakdown strength | DC | kV/mm | >30 | >30 |

**Claims**

1.  A ceramic substrate comprising:

    - aluminum oxide ($Al_2O_3$) with an average grain size between 1.0 and 1.9 $\mu$m, preferably between 1.2 and 1.7 $\mu$m, more preferably between 1.3 and 1.6 $\mu$m, even more preferably between 1.31 and 1.55 $\mu$m;
    - Zirconium dioxide ($ZrO_2$) with an average grain size between 0.51 and 1.0 $\mu$m, preferably between 0.55 and 0.9 $\mu$m, more preferably between 0.6 and 0.8 $\mu$m, even more preferably between 0. 65 and 0.75 $\mu$m,
    - Yttrium oxide ($Y_2O_3$), siliocon oxide ($SiO_2$) and further components.

2.  Ceramic substrate according to claim 1, **characterized by**

    - 85-95 wt%, preferably 88- 93 wt%, more preferably 89-91 wt% (based on the overall weight of the ceramic substrate) of aluminum oxide ($Al_2O_3$),
    - 4 - 14 wt%, preferably 6-11 wt%, more preferably 8-10 wt% (based on the overall weight of the ceramic substrate) of zirconium dioxide ($ZrO_2$)
    - 0.2-0.8 wt%, preferably 0.3-0.7 wt%, more preferably 0.4 - 0.6 wt% (based on the overall weight of the ceramic substrate) of yttrium oxide ($Y_2O_3$),
    - 0.1-0.5 wt%, preferably 0.2-0.4 wt%, more preferably 0.25 - 0.35 wt% (based on the overall weight of the ceramic substrate) of silicon oxide ($SiO_2$), and
    - Less than 0.6 wt%, preferably 0.1 - 0.45 wt%, more preferably 0.2 - 0.35 wt%(based on the overall weight of the ceramic substrate) further components, wherein the sum of all ingredients always adds up to 100wt%.

3.  Ceramic substrate according to one of the preceding claims **characterized by** a bending strength (measured according to ASTM C1499-15) of more than 620 MPa, preferably of more than 650 MPa, more preferably of more than 670 MPa, even more preferably of more than 680 MPa, such as 690 MPa.

4.  Ceramic substrate according to one of the preceding claims **characterized by** a thermal conductivity (measured at 20 °C according to ISO 18755:2005) of more than 20 W/m*K, preferably of more than 22 W/m*K, even more preferably of more than 24 W/m*K.

5.  Ceramic substrate according to one of the preceding claims **characterized by** Modulus of elasticity (Young's Modulus) of more than 310 GPa, preferably of more than 350 GPa, even more preferably of more than 360 GPa.

6. Ceramic substrate according to one of the preceding claims **characterized by** a fracture toughness $K_{Ic}$ Niihara (measured according to the IF-method) of 3-5 MPa m$^{1/2}$, preferably of 3.5 - 4.5 MPa m$^{1/2}$, more preferably of 3.8-4.2 MPa m$^{1/2}$.

7. Ceramic substrate according to one of the preceding claims **characterized by** a surface roughness Ra (measured according to DIN EN ISO 4288) of less than 0.5 $\mu$m, preferably of less than 0.4 $\mu$m, more preferably of less than 0.2 $\mu$m, such as 0.19 $\mu$m.

8. Method for obtaining a ceramic substrate according to one of the preceding claims comprising the following steps

   - Providing a mixture of at least one first type of aluminum oxide having a particle size between d50 0,.1-0.8 $\mu$m, preferably d50 0.3-0.6 $\mu$m and at least one second type of aluminum oxide having a particle size between d50 0.9-1.7 $\mu$m, preferably 1.0-1.5 $\mu$m;
   - Providing a mixture of at least one first type of zirconium oxide having a particle size between d50 0.2-0.5 $\mu$m preferably d50 0.25-0.35 $\mu$m and at least one second type of zirconium oxide having a particle size between d50 0.8-1.4 $\mu$m, preferably d50 0.9-1.25 $\mu$m;
   - Combining the aluminum oxide mixture and the zirconium oxide mixture and dispersing the mixture in a mill,
   - Adding a binder to the dispersed mixture of aluminum oxide and zirconium oxide,
   - Shaping the dispersed mixture of aluminum oxide, zirconium oxide and binder into a desired form by injection molding, and
   - Sintering the molded mixture to provide the ceramic substrate.

9. Method according to claim 8, **characterized in that**

   - 42.5 - 47.5 wt%, preferably 44 - 46.5 wt%, more preferably 44.5- 45.5 wt% of the at least one first type of aluminum oxide having a particle size between d50 0.1-0.8, preferably d50 0.3-0.6 $\mu$m and
   - 42.5 - 47.5 wt%, preferably 44 - 46.5 wt%, more preferably 44.5- 45.5 wt% of the at least one second type of aluminum oxide having a particle size between d50 0.9-1.7, preferably 1.0-1.5 $\mu$m ,

   are provided.

10. Method according to one of claims 8-9, **characterized in that**

    - 1.2 - 4.2 wt%, 1.8 - 3.3 wt%, 2.4 -3 wt% of the at least one first type of zirconium oxide having a particle size between d50 0.2-0.5 $\mu$m preferably d50 0.25-0.35 $\mu$m, and
    - 2.8 - 9.8 wt%, 4.2 - 7.7 wt%, 5.6 - 7 wt% of the at least one second type of zirconium oxide having a particle size between d50 0.8-1.4 $\mu$m, preferably d50 0.9-1.25 $\mu$m are provided.

11. Method according to one of the claims 8-10, **characterized in that** sintering aids such as $SiO_2$ and organic compounds are added

12. Method according to one of the claims 8-11, **characterized in that** the sintering step is carried out at temperatures between 1400 and 1700°C.

13. Use of a ceramic substrate according to one of the claims 1-7 in an electronic device.

14. An electronic device comprising a ceramic substrate according to one of the claims 1-7.

Europäisches
Patentamt

European
Patent Office

Office européen
des brevets

# EUROPEAN SEARCH REPORT

Application Number

EP 22 16 1680

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 786 134 A1 (KYOCERA CORP [JP]) 3 March 2021 (2021-03-03) | 1-8, 12-14 | INV. C04B35/119 C04B35/634 H01L29/00 H01L33/00 H05K1/03 |
| A | * claims 1, 2, 9 * * paragraphs [0029], [0031], [0045], [0047] - [0049], [0069] - [0073], [0077] * * examples 2-4, 7-8; table 1 * | 9,10 | |
| X,D | EP 3 315 476 B1 (KYOCERA CORP [JP]) 26 February 2020 (2020-02-26) | 1,2,4-6, 13,14 | |
| A | * claims 1, 6 * * paragraphs [0040] - [0047], [0057] * * examples 1, 7, 8; table 1 * | 8,9,11, 12 | |
| X | US 2021/261473 A1 (UMEDA YUJI [JP] ET AL) 26 August 2021 (2021-08-26) | 1,3,13, 14 | |
| A | * claim 9 * * paragraphs [0067] - [0068], [0071] - [0087] * * examples 5, 11, 14-16, comp. ex.1; table 1 * | 8,11,12 | |

TECHNICAL FIELDS SEARCHED (IPC)

C04B
H01L
H05K

The present search report has been drawn up for all claims

| Place of search | Date of completion of the search | Examiner |
|---|---|---|
| The Hague | 17 August 2022 | Buffet, Noemie |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 16 1680

This annex lists the patent family members relating to the patent documents cited in the above-mentioned European search report.
The members are as contained in the European Patent Office EDP file on
The European Patent Office is in no way liable for these particulars which are merely given for the purpose of information.

17-08-2022

| Patent document cited in search report | | | Publication date | Patent family member(s) | | | Publication date |
|---|---|---|---|---|---|---|---|
| EP | 3786134 | A1 | 03-03-2021 | CN | 112041286 | A | 04-12-2020 |
| | | | | EP | 3786134 | A1 | 03-03-2021 |
| | | | | JP | 6987981 | B2 | 05-01-2022 |
| | | | | JP | WO2019208438 | A1 | 10-06-2021 |
| | | | | WO | 2019208438 | A1 | 31-10-2019 |
| EP | 3315476 | B1 | 26-02-2020 | EP | 3315476 | A1 | 02-05-2018 |
| | | | | JP | 6496021 | B2 | 03-04-2019 |
| | | | | JP | WO2016208766 | A1 | 19-04-2018 |
| | | | | WO | 2016208766 | A1 | 29-12-2016 |
| US | 2021261473 | A1 | 26-08-2021 | CN | 112789256 | A | 11-05-2021 |
| | | | | EP | 3854766 | A1 | 28-07-2021 |
| | | | | JP | 7062087 | B2 | 02-05-2022 |
| | | | | JP | WO2020115868 | A1 | 30-09-2021 |
| | | | | US | 2021261473 | A1 | 26-08-2021 |
| | | | | WO | 2020115868 | A1 | 11-06-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2911994 B1
- EP 3315476 B1

**Non-patent literature cited in the description**

- **A. G. EVANS ; E. A. CHARLES.** *J. Am. Ceram. Soc.,* 1976, vol. 56, 371-372
- **G. R. ANSTIS ; P. CHANTIKUL et al.** *J. Am. Ceram. Soc.,* 1981, vol. 64, 533-538